# EUROPEAN PATENT SPECIFICATION

(11) **EP 0 982 751 B1**
(45) Date of publication and mention of the grant of the patent: **19.03.2003**
(21) Application number: 99116988.9
(22) Date of filing: 27.08.1999
(51) Int. Cl.: H01J 5/56, H01K 1/46, H01K 7/04

(54) **Subminiature lamp for indication light**
Subminiaturlampe für Anzeigeleuchte
Lampe subminiature pour lumière d'indication

(30) Priority: 28.08.1998 JP 24382298
(43) Date of publication of application: 01.03.2000
(73) Proprietor: Stanley Electric Co., Ltd., Meguro-ku Tokyo 153-8636 (JP)
(72) Inventor: Shozo, Maeno, c/o Stanley Electric Co., Ltd., Tokyo 153-8636 (JP); Daishin, Sato, c/o Stanley Electric Co., Ltd., Tokyo 153-8636 (JP); Katsuhito, Yamaguchi, c/o Stanley Electric Co.,Ltd, Tokyo 153-8636 (JP)
(74) Representative: Wagner, Karl H., Dipl.-Ing.

(56) References cited:
- US-A- 5 062 818

## Description

### BACKGROUND OF THE INVENTION

### Field of the invention

This invention relates to a subminiature lamp used as a signal or any indication light for home appliances, audio-visual products and office equipment, or the like, and more particularly to a design and a method of installing a subminiature lamp at is used with a socket adapted to be disposed on a printed wiring or circuit board by soldering, or the like.

### Discussion of the Related Art

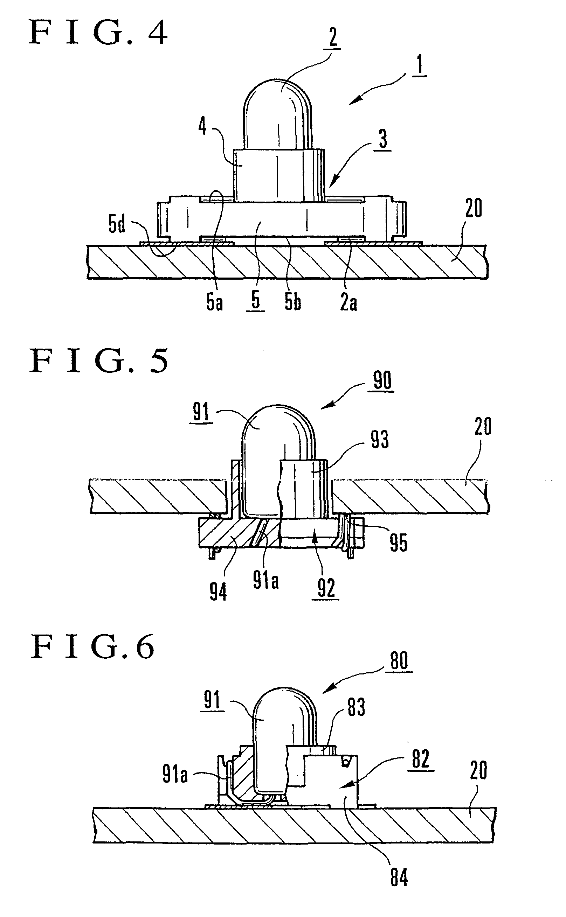

Figs. 5 and 6 illustrate conventional subminiature lamps used as a signal or indication light. The subminiature lamp 90 in Fig. 5 has a design to be mounted from the back surface of a printed wiring board 20. This subminiature lamp 90 is comprised of a bulb 91, a socket 92, and a pair of lead wires 91a penetrating through the socket 92. The socket 92 includes a bulb holder 93 which is formed as a cylinder with a bottom to maintain the bulb 91 within the cylinder, and a socket base 94 to mount the subminiature lamp 90 on the printed wiring board 20.

A conventional method to mount the bulb 91 on the socket 92 comprises the steps of mounting the bulb 91 in the bulb holder 93 and pulling out the pair of lead wire 91a through each hole from the bottom of the bulb holder 93 to the back surface of socket base 94. Each of the pair of lead wires 91a is wound around each end 95 of the socket base 94.

Since the bulb 91 is installed by being penetrated through the printed wiring board 20, the back surface of the printed wiring board 20 faces the front surface of the socket base 94. Thus the front surface of the socket base 94 must be designed to satisfy mounting requirements.

The subminiature lamp 80 in Fig. 6 has a design such that it is installed on the front surface of the printed wiring board 20. This subminiature lamp 80 is comprised of a bulb 91, a socket 82, and a pair of lead wires 91a passing through the socket 82. The socket 82 includes a bulb holder 83 which is formed as a cylinder with a bottom to maintain the bulb 91 within the cylinder, and a socket base 84 to mount the subminiature lamp 80 on the printed wiring board 20. In this design, since the subminiature lamp 80 is installed on the front surface of the printed wiring board 20, meaning not passing through the printed wiring board, the socket base 84 touches the printed wiring board 20 on the side not having the bulb holder 83, meaning the back surface of the socket base 84. A lamp of this kind is disclosed in US Patent 5,062,818 A.

The conventional subminiature lamps 90 and 80 have following problems. First, the designs of the subminiature lamps 90 and 80 accompany some low productive and troublesome work when the lamps 90 or 80 are mounted on the printed wiring board 20, because the lead wire 91a is very fine and must go through the socket bases 94 and 84 by passing through holes existing in the bottom portion of the bulb holder 93 and 83. Second, since there are differences with respect to how to mount the subminiature lamp 90 and 80 on the printed wiring board 20, even though the required properties of the subminiature lamp is the same, two kinds of the subminiature lamps 90 and 80 are required depending on the mounting conditions designated by customers. This may often cause the change of production plan and lowering productivity.

### SUMMARY OF THE INVENTION

The present invention is directed to a subminiature lamp for indication purposes that substantially obviates one or more of the above problems due to the limitations and disadvantages of the conventional bulbs.

It is an object of the present invention to improve productivity reducing troublesome handling and work when the subminiature lamp is mounted on a printed wiring board.

It is another object of the invention to reduce the number of parts and the production cost by providing common parts of the subminiature lamp for various mounting methods of the subminiature lamp on the printed wiring board.

According to the present invention, the above objects are achieved by providing a subminiature lamp comprising a bulb with lead wires, a socket having a socket base with terminal ends of lead wire and a surface facing a printed wiring board when mounted on it, and a bulb holder holding a bulb in a predetermined direction relative to the socket base, wherein the socket base is formed as a flat plate and its front and back surfaces are parallel to each other, and wherein the bulb holder is substantially a cylinder with a bottom corresponding to a portion of the front surface of the socket base. A slit extends along a diameter of the cylinder from top portion of the side surface of the bulb holder to the front surface of the socket base, and wherein when the bulb is disposed within an internal diameter of the bulb holder, the lead wire of the bulb is pulled outside through the slit and lies along the front and back surfaces of the socket base.

### BRIEF DESCRIPTION OF THE DRAWINGS

The accompanying drawings, which are included to provide a further understanding of the invention, illustrate embodiments of the invention and together with the description serve to elucidate the principles of the invention:
Fig. 1 is a perspective view of a first preferred embodiment of the present invention.
Fig. 2 is a partly cross sectional view along the line A-A of the first preferred embodiment of the present invention, shown in Fig. 1.
Fig. 3 is a diagram of the first preferred embodiment of the present invention showing an example when the first preferred embodiment is mounted on a printed wiring board.
Fig. 4 is a diagram of the first preferred embodiment of the present invention showing another example when the first preferred embodiment is mounted on a printed wiring board.
Fig. 5 is a diagram, partly in section, of a conventional subminiature lamp.
Fig.6 is a diagram, partly in section, of another conventional subminiature lamp.

### DETAILED DESCRIPTION OF THE PREFERRED EMBODIMENTS

The preferred embodiments of the present invention will be described with reference to the drawing.

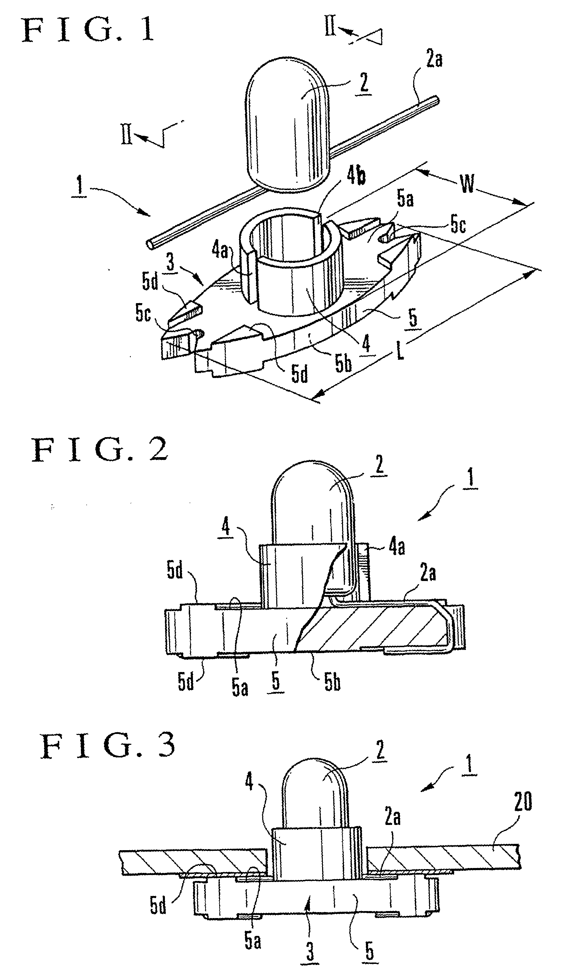

The subminiature lamp 1 in Figs. 1 and 2 comprises, similar to a conventional subminiature lamp, a bulb 2 with lead wires 2a and a socket 3. The socket 3 comprises a substantially cylindrical bulb holder 4 and a socket base 5.

In this embodiment, the bulb holder 4 is a cylinder with a bottom which is a portion of a front or upper surface 5a of the socket base 5. A slit 4a is formed along a diameter of the cylinder of the bulb holder 4. The slit 4a also extends downwardly in vertical direction, from one end i.e. a top portion 4b of the bulb holder 4, to the front surface 5a of the socket base 5. The bulb 2 is disposed within an internal diameter of the bulb holder 4.

The socket base 5 is formed to be a rectangular or elliptic plate, or the like, whose longitudinal length L is longer than the width W. The front or upper surface 5a and a back or lower surface 5b are parallel to each other. The slit 4a extends along the longitudinal length L.

A guide recess 5c is formed in both ends of the socket base 5 in the direction of the longitudinal length L, said guide recesses 5c guide and receive or introduce a respective lead wire 2a of the bulb 2 from the front surface 5a to the back surface 5b. This guide recess 5c may reach (as shown) the back surface 5b, if necessary. For example, as shown, this guide recess 5c may extend from the front surface 5a through the plate 5 to the back surface 5b in order to form a return passage of the lead wire 2a.

In addition, the socket base 5 further comprises projections 5d, formed on both ends of the socket base 5 in the width direction and preferably also (as shown) in the longitudinal direction. The lead wire 2a passes through, between said respective projections. The height of each of said projections 5d is substantially the same as an extending or projecting portion of the lead wire 2a when it is disposed on the surfaces 5a and 5b of the socket base 5. In this embodiment (as shown), there are two lead wires 2a and each lead wire 2a is respectively installed to extend from the front surface 5a to the back surface 5b passing between the respective widthwise facing projections 5d. Accordingly, four projections 5d may be formed on only one surface 5a or 5b. Otherwise, eight projections 5d may be formed on both surfaces 5a and 5b (as shown).

The following explanation is with regard to the operation and effect of subminiature lamp 1 of the design described above. Since the bulb holder 4 has the slit 4a, in the production process or assembly of the subminiature lamp 1, the bulb 2 is mounted in the bulb holder 4 such that the lead wires 2a are in a straight line and pass through the slit 4a. The attachment of the bulb 2 on the bulb holder 4 is performed in accordance with the positions of the slit 4a and lead wires 2a.

The operational advantages of the subminiature lamp 1 according to the preferred embodiment of the present invention will be described. First, the subminiature lamp 1 greatly improves productivity as compared to the conventional subminiature lamps 90 or 80, because the complicated work such as pulling the lead wire 91a out from the bulb holder 93 or 83 through the through hole of the bottom of the bulb holder 93 or 83 is omitted. Furthermore, a process of winding the lead wire 2a around the end 95 of the socket base 94 is not required. After the bulb 2 is inserted, the lead wires 2a are bent along the predetermined passage on the one surface 5a. The lead wires 2a are attached to the guide ditch 5c formed on the end in the width direction L, then the bulb 2 is fixed on the socket base 5.

Second, since the socket 5 can be shared for mounting the subminiature lamp 1 from both front and back surfaces of the printed wiring board 20, production efficiency is greatly improved. The subminiature lamp 1 may be attached from the back surface of a printed wiring board 20 as shown , in Fig. 3, or can be attached from the front surface of a printed wiring board 20 as show in Fig. 4, because the front surface 5a and the back surface 5b are flat and parallel each other and the lead wires 2a are laid along the surfaces 5a and 5b.

Third, when the bulb 2 is attached to the printed wiring board 20, the projections 5d provide a space between the surfaces 5a and 5b and the printed wiring board 20. Thus, inclined disposition of the subminiature lamp 1 is prevented, and more precise dimension control is achieved.

## Claims

1. A subminiature lamp (1) used as a signal or any indication, the lamp comprising a bulb (2) with lead wires (2a) and a socket (3), the socket (3) comprising a socket base (5) having a surface (5a) for attachment and terminal ends of the lead wire (2a), a bulb holder (4) holding the bulb (2) in a predetermined position: **characterized in that**
a front surface (5a) and a back surface (5b) of the socket base (5) form a substantially flat plate and are parallel to each other;
the bulb holder (4) is attached on the front surface (5a) of the socket base (5) and the shape of the bulb holder (4) is substantially a cylinder with a bottom corresponding to a portion of the front surface (5a) of the socket base (5);
a slit (4a) extends in the direction of diameter of the bulb holder (4) from a top portion (4b) of the bulb holder (4) to the front surface (5a) of the socket base (5);
the bulb (2) is attached within an internal diameter of the bulb holder (4); and
the lead wires (2a) of the bulb (2) pulled out by way of the slit (4a) are disposed along the front and back surfaces (5a and 5b) of the socket base (5).

2. The subminiature lamp (1) of claim 1 comprising at least a pair of projections (5d) formed on one surface (5a or 5b) of the socket base (5) between which the lead wires (2a) pass through.

3. The subminiature lamp (1) of claim 2, wherein the height of the projection (5d) substantially corresponds to the height of the lead wires (2a) disposed on the front surface (5a) of the socket base (5).

4. A subminiature lamp (1) of claim 1,**characterized in that** a guide recess (5c) is formed in an end of the socket base (5) to introduce a lead wire (2a) from a front surface (5a or 5b) of the socket base (5) to a back surface (5a or 5b) of the socket base (5).

## Patentansprüche

1. Eine Subminiaturlampe (1) die als ein Signal oder irgendeine Anzeige verwendet wird, wobei die Lampe Folgendes aufweist:
eine Birne (2) mit Zuleitungen (2a) und einem Sockel (3), wobei der Sockel (3) eine Sockelbasis (5) mit einer Oberfläche (5a) zur Befestigung und Anschlussenden der Zuleitungen (2a) aufweist, einen Birnenhalter (4), der die Birne 2 in einer vorbestimmten Position hält: **dadurch gekennzeichnet, dass**
eine Vorderseite (5a) und eine Rückseite (5b) der Sockelbasis (5) eine im Wesentlichen flache Platte bilden und parallel zueinander liegen;
der Birnenhalter (4) an der Vorderseite (5a) der Sockelbasis (5) angebracht ist und die Form des Birnenhalters (4) im Wesentlichen ein Zylinder mit einem Boden ist, der einem Teil der Vorderseite (5a) der Sockelbasis (5) entspricht;
sich ein Schlitz (4a) in die Richtung des Durchmessers des Birnenhalters (4) erstreckt und zwar von einem Oberteil (4b) des Birnenhalters (4) zu der Vorderseite (5a) der Sockelbasis (5);
die Birne (2) innerhalb eines Innendurchmessers des Birnenhalters (4) befestigt ist; und
die Zuleitungen (2a) der Birne (2), die über den Schlitz (4a) herausgezogen sind, entlang der Vorder- und Rückseiten (5a und 5b) der Sockelbasis (5) angeordnet sind.

2. Subminiaturlampe (1) nach Anspruch 1, die wenigstens ein Paar von Vorsprüngen (5d) aufweist, die an einer Oberfläche (5a oder 5b) der Sockelbasis (5) ausgebildet sind, und zwischen denen die Zuleitungen (2a) hindurchgehen.

3. Die Subminiaturlampe (1) nach Anspruch 2, wobei die Höhe des Vorsprungs (5d) im Wesentlichen der Höhe der Zuleitungen (2a), die an der Vorderseite (5a) der Sockelbasis (5) angeordnet sind, entspricht.

4. Subminiaturlampe (1) nach Anspruch 1, **dadurch gekennzeichnet, dass** eine Führungsausnehmung (5c) in einem Ende der Sockelbasis (5) ausgebildet ist zum Einführen einer Zuleitung (2a) von einer Vorderseite (5a oder 5b) der Sockelbasis (5) zu einer Rückseite (5a oder 5b) der Sockelbasis (5).

## Revendications

1. Lampe subminiature (1) utilisée comme signalisation ou voyant, la lampe comprenant une ampoule (2) avec des fils conducteurs (2a) et une douille (3), la douille (3) comprenant une embase de douille (5) ayant une surface (5a) pour la fixer et fixer des bornes du fil conducteur (2a), un support d'ampoule (4) maintenant l'ampoule (2) dans une position prédéterminée, **caractérisée en ce que** :
la face avant (5a) et la face arrière (5b) de l'embase de douille (5) forment une plaque sensiblement plane et sont parallèles l'une à l'autre ;
le support d'ampoule (4) est fixé à la face avant (5a) de l'embase de douille (5) et la forme du support d'ampoule (4) est sensiblement un cylindre avec un fond qui correspond à une partie de la face avant (5a) de l'embase de douille (5) ;
une fente (4a) s'étend dans la direction du diamètre du support d'ampoule (4) à partir d'une partie supérieure (4b) du support d'ampoule (4) vers la face avant (5a) de l'embase de douille (5) ;
l'ampoule (2) est fixée dans un diamètre interne du support d'ampoule (4) ; et
les fils conducteurs (2a) de l'ampoule (2) tirés vers l'extérieur au moyen de la fente (4a) sont disposés le long des faces avant et arrière (5a, 5b) de l'embase de douille (5).

2. Lampe subminiature (1) selon la revendication 1, comprenant deux parties en saillie (5d) formées sur une face (5a ou 5b) de l'embase de douille (5) entre lesquelles passent les fils conducteurs (2a).

3. Lampe subminiature (1) selon la revendication 2, dans laquelle la hauteur de la saillie (5d) correspond sensiblement à la hauteur des fils conducteurs (2a) disposés sur la face avant (5a) de l'embase de douille (5).

4. Lampe subminiature (1) selon la revendication 1, **caractérisée en ce qu'**un évidement de guidage (5c) est formé dans une extrémité de l'embase de douille (5) pour introduire un fil conducteur (2a) à partir d'une face avant (5a ou 5b) de l'embase de douille (5) vers une face arrière (5a ou 5b) de l'embase de douille (5).
